Europäisches Patentamt

(19) European Patent Office

Office européen des brevets

(11) Publication number: **0 077 408**

**A1**

## (12) EUROPEAN PATENT APPLICATION

(21) Application number: **81108421.9**

(22) Date of filing: **16.10.81**

(51) Int. Cl.³: **H 01 L 21/68**
**C 30 B 35/00**

(43) Date of publication of application:
**27.04.83 Bulletin 83/17**

(84) Designated Contracting States:
**AT BE CH DE FR GB IT LI LU NL SE**

(71) Applicant: **A.M. Micro Technology AG**
**Neuschwändistrasse 5**
**CH-6390 Engelberg(CH)**

(72) Inventor: **Wirz, Gustav**
**Andhausen 404**
**CH-8572 Berg/TG(CH)**

(74) Representative: **Glawe, Delfs, Moll & Partner**
**Patentanwälte**
**Postfach 26 01 62 Liebherrstrasse 20**
**D-8000 München 26(DE)**

(54) **A method and apparatus for the heat treatment of semiconductor articles.**

(57) A method and apparatus for the heat-treatment, such as vapour deposition, of semiconductor wafers is disclosed, wherein a holder (1) loaded with wafers (5) is moved in vertical direction through a heating zone (12) without touching the wall thereof. The holder or boat may be a trough cage formed of end pieces and connecting rods of quartz and can be suspended on one end at a suspension device (21, 22) of a lifting and lowering means (19, 20), which may be combined with a cover (15) for the tubular heating zone. Deposition of particles from the wall of the heating zone on the wafers is thereby advantageously avoided.

Fig. 4

EP 0 077 408 A1

A method and apparatus for the heat treatment of semi-
conductor articles
-----------------------------------------------------------

The invention relates to the heat treatment of semiconductor articles, and more particularly, though not exclusively, to a method of vapour deposition on silicon wafers for providing them with a surface layer of silicon, polysilicon, silicon nitride, silicon dioxide or the like.

The invention may also be used for other heat treatments to which semiconductor devices may be subjected for the purposes of diffusion, oxidation, annealing, deposition, alloying and the like.

The present practice for carrying out vapour deposition on silicon wafers is to use a high temperature furnace comprising a high purity quartz tube arranged in a horizontal position, to which treatment gas carrying the vapour is introduced in one end and exhausted from the other end. The quartz tube can operate at atmosphere pressure or under a reduced pressure, typically 200-800 millitorr. Silicon wafers are positioned on holders, usually called boats or sleds, made of quartz, and these holders are inserted by pushing into the heating zone of the tube.

It is well-known in the art that the losses encountered in this method are very high and the yield of good quality, faultless wafers is very low, typically below 20%. One major reason for these losses is that small, solid particles may be formed of and detached from the layer vapour-deposited on the surface of the tube and the holder and may adhere to the silicon wafers. One adhering particle of the size of only one micron may be sufficient to make the wafer unsuitable for further use, especially where the wafer is intended for a semiconductor device carrying high density MOS circuits. Another cause for losses can reside in excessive, uncontrolled deviation of the temperature distribution in the tube from a desired temperature profile.

It is an object of the invention to provide a method of the aforementioned kind and an apparatus for carrying out the method whereby the aforementioned causes for losses can be substantially reduced and the yield of useful semiconductor articles will be significantly increased.

The invention provides a method of heat treating of semiconductor articles, such as silicon wafers, where a holder loaded with the articles is moved into and out of a substantially tubular heating zone and a treatment gas and/or vapour is supplied to and or exhausted from said heating zone, characterized in that said holder is moved in a substantially vertical direction without any mechanical contact with the wall of said heating zone.

It has been found that by avoiding mechanical contact between the holder and the wall of the tube the generation of particles which may deposit on the wafers can be almost completely eliminated. This results in a significant increase of the yield of the process, without recurring to hither to necessary treatments such as a chemical washing of the tube after each production run, or of the treated wafers.

The current of treatment gas and/or vapour through the heating zone is preferably also generated in a vertical direction upward or downward. This measure has merits of its own. It has been surprisingly found that in a vertical furnace tube through which the gas or vapour is flowing in a vertical direction, a desired temperature profile and be controlled and maintained with much better accuracy than in a horizontal tube, and uncontrolled deviations from the desired temperature profile, which may result in ununiform vapour deposition on the wafers, can be significantly reduced.

Preferably, in the case of generally disc-shaped semiconductor articles or wafers, these articles are arranged in said holder vertically spaced from and parallel to each other. A suitable holder for this purpose comprises two end pieces which are connected by three or four longitudinal rods to form a trough-shaped structure which is open at one side for inserting the wafers, and a releasable locking bar which may be inserted in two openings of the end pieces so as to extend parallel to the longitudinal rods to engage the upper edges of the inserted wafers for preventing them from falling out of the trough-shaped structure. Equidistant slots or notches may be provided in said rods for locating the wafers in their spaced arrangement. The holder may then be suspended with its axis substantially vertical by suspension means engaging with one of said end pieces.

Preferred embodiments of the invention will be described with reference to the accompanying drawings.

Fig. 1 is a prospective view of a holder or boat
        for semiconductor wafers according to a
        preferred embodiment of the invention.

Fig. 2 and 3   show in an enlarged scale an end-view
               and side-view, respectively, of the
               holder of fig. 1.

Fig. 4 is a schematic elevation view of a heat treatment apparatus according to one preferred embodiment of the invention.

Fig. 5 is a schematic elevation view of a heat treatment apparatus according to another embodiment
        of the invention.

Fig. 6 and 7   show a plan-view and elevation, respectively, of a further embodiment of a holder.

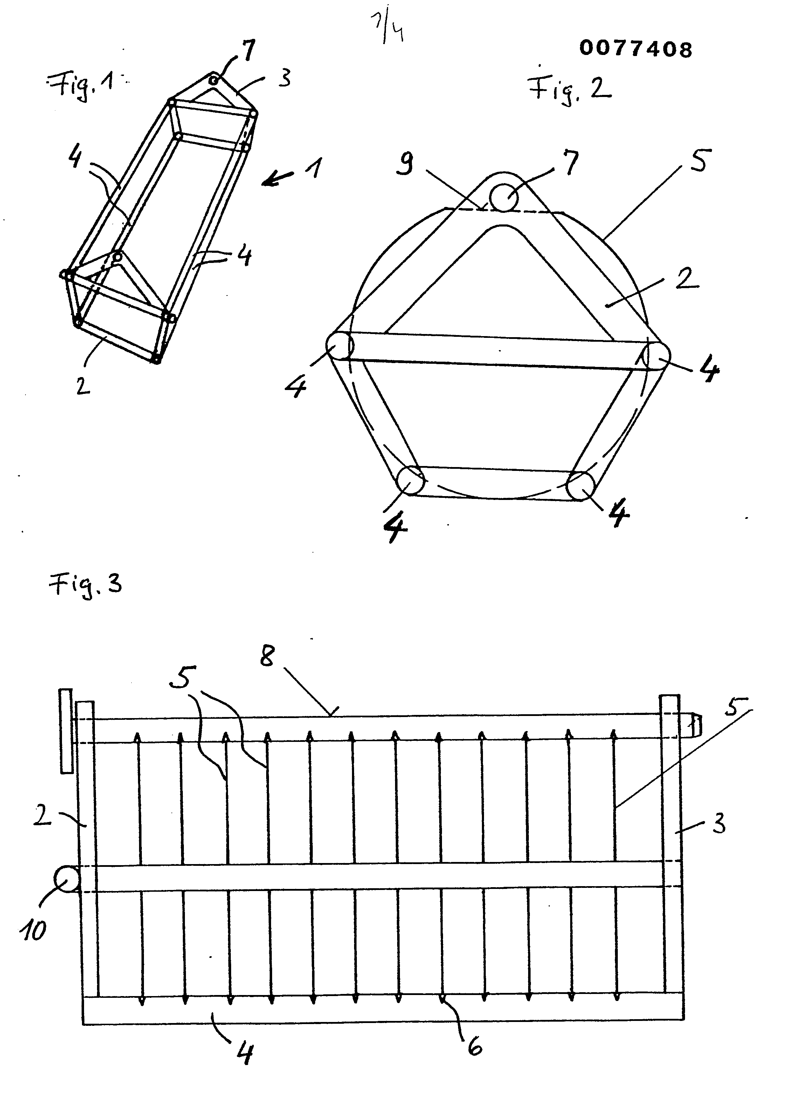

The holder or boat 1 shown in fig. 1 to 3 is made completely of quartz and comprises two end pieces 2, 3,
which are substantially pentagon-shaped and which are
interconnected at four of the five corners of the
pentagon by four parallel longitudinal rods 4 so as
to form a rigid through-shaped structure, as depicted
in fig. 1, which is open towards its upper side so
that substantially circular, disc-shaped wafers 5 may be inserted. The longitudinal rods 4 are provided with slots or notches 6 into which the edges of the wafers 5 engage for locating the wafers 5 in a substantially parallel, equidistant arrangement. The top corner of each of the end pieces 2, 3 is provided with an opening 7 into which a locking rod 8 may be inserted so as to extend parallel to the longitudinal rods 4 and to engage with the normally flattened upper edge 9 of the wafers 5 to lock them in their position in the holder 1.

One of the end pieces 2, 3 is provided with a cross bar 10 which may be engaged by a suspension hook so as to suspend the holder 1 in a position, where its axis will be substantially vertical and the wafers 5 will be arranged substantially horizontal and vertically spaced from each other.

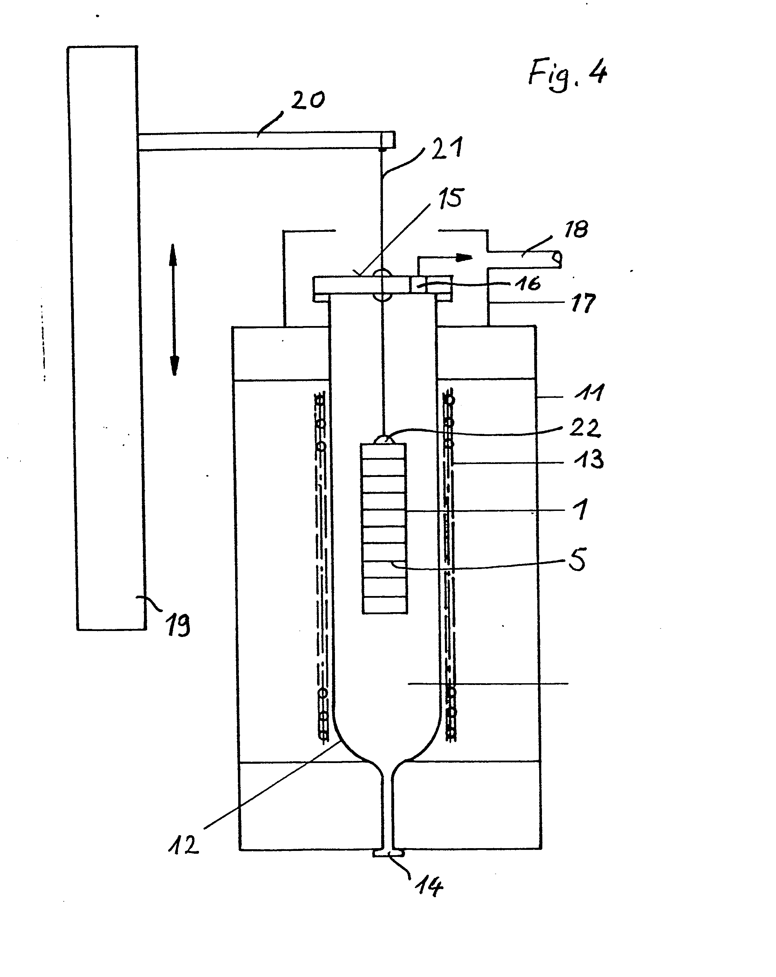

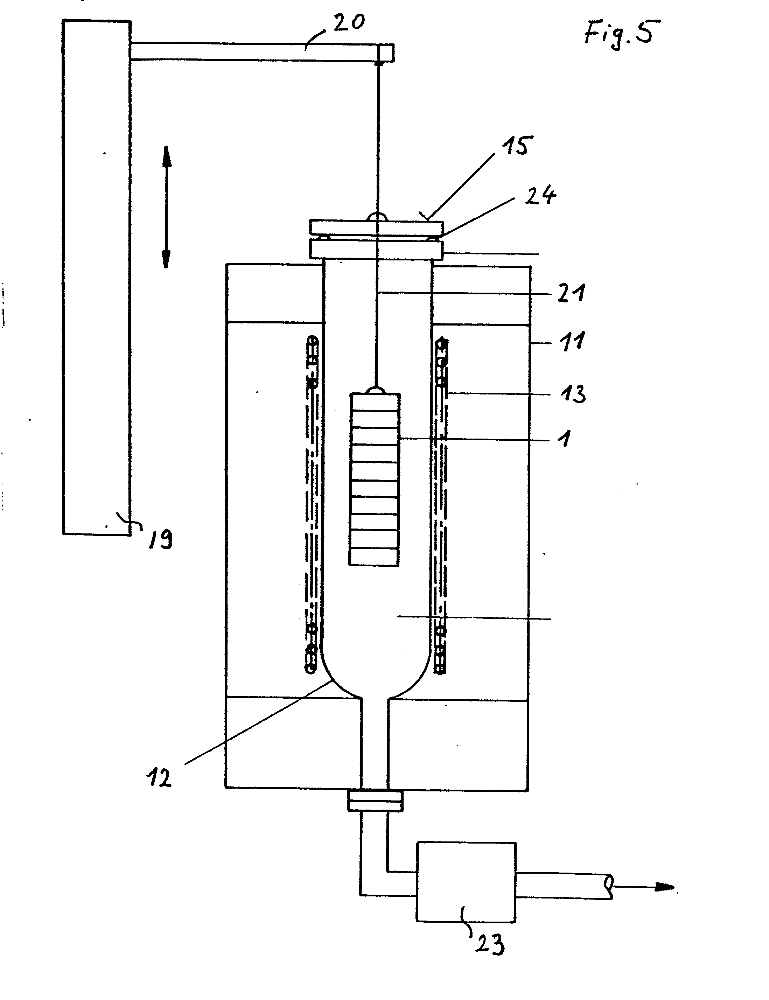

The holder 1 loaded with silicon wafers 5 as shown and described in connection with figures 1 to 3 may be used in any of the heat treatment apparatus which will now be described in connection with figures 4 and 5.

The apparatus shown in fig. 4 is an apparatus for
heat treatment of the wafers under atmospheric
pressure. Typical uses of such apparatus are
diffusion, oxidation, annealing or alloying,and
the treatment may be carried out in the presence
of a process gas and with a temperature typically
in the range between 400$^{\circ}$ and 1200$^{\circ}$ C.

Reference numeral 11 depicts a furnace with suitable
heat insulation, which encloses a process tube 12
made of quartz, which is surrounded by a heating
element 13. The process tube 12 is arranged with its
axis substantially vertical. The lower end of the
process tube 12 is provided with a connection 14 for
the supply of a process gas. The upper end of the
process tube 12 can be closed by a cover 15 which has
a venting opening 16 which opens into an exhaust
manifold 17 from which the process gas may be
exhausted through an exhaust tube 18. An elevator or
lift mechanism 19 is arranged at a suitable position
besides the furnace 11 and has a lifting arm or
gallows 20 from which the holder or boat 1 with the
silicon wafers 5 may be suspended by means of a quartz
wire or rod 21 which may be provided with hook means 22 for engaging with the cross bar 10 of the holder 1 as already described in connection with figures 1 to 3. The cover 15 may also be connected to the quartz rod 21 so as to be suspended from the arm 20. When lowering the holder 1 into the tube 12, the cover 15 will be automatically lowered into its closing position, which intern will determine the predetermined position of the holder 1 within the process tube 12.

The elevator or lift mechanism 19 may be of any suitable kind which will ensure a precise and substantially shock free lifting and lowering movement of the arm 20 and the suspended holder 1. For example, the lift mechanism 19 may comprise a rotatable lead screw which is engaged by a threaded nut connected to the arm 20. Alternatively the lift mechanism 19 my comprise a pneumatic or hydraulic lifting means for the arm 20.

The apparatus shown in fig. 5 is an apparatus for the heat treatment of silicon wafers under a reduced pressure, typically for low pressure chemical vapour deposition. Typical treatment pressures may be in the range of 0,2 to 1 Torr and typical treatment temperatures in the range of 600 to 950$^{o}$ C.

The general structure of the apparatus is similar to that of fig. 5, and corresponding parts are designated with the same reference numerals and will not be described again. The quartz process tube 12 with vertical axis is connected at its upper end to a vacuum pump 23 for maintaining the required low pressure within the tube 12. The upper end of the tube 12 is sealed by the cover 15, which is seated against a vacuum seal gasket 24 surrounding the top opening of the tube 12. The cover 15 and the holder 1 are again suspended from the arm 20 of the lift mechanism 19 so as to be lowered into or lifted out of the tube 12 without any engagement with the wall of the tube 12.

It is obvious to the man skilled in the art that modifications of the described embodiments or other ways of putting the invention into practice are possible without departing from the concept of the invention which is more clearly defined in the accompanied claims.

For example the locking rod 8 may be a smooth rod
without locating slots or notches 6. Alternatively,
the locking rod 8 may have a flattened side without slots or notches, and a peripheral part provided with slots or notches 6, and in said case the
rod 8 will be inserted into the openings 7 with the
flattened side facing the wafer edges 9, and after
insertion the rod 9 may be rotated so as to bring
the slots or notches 6 into engagement with the
wafers 5.

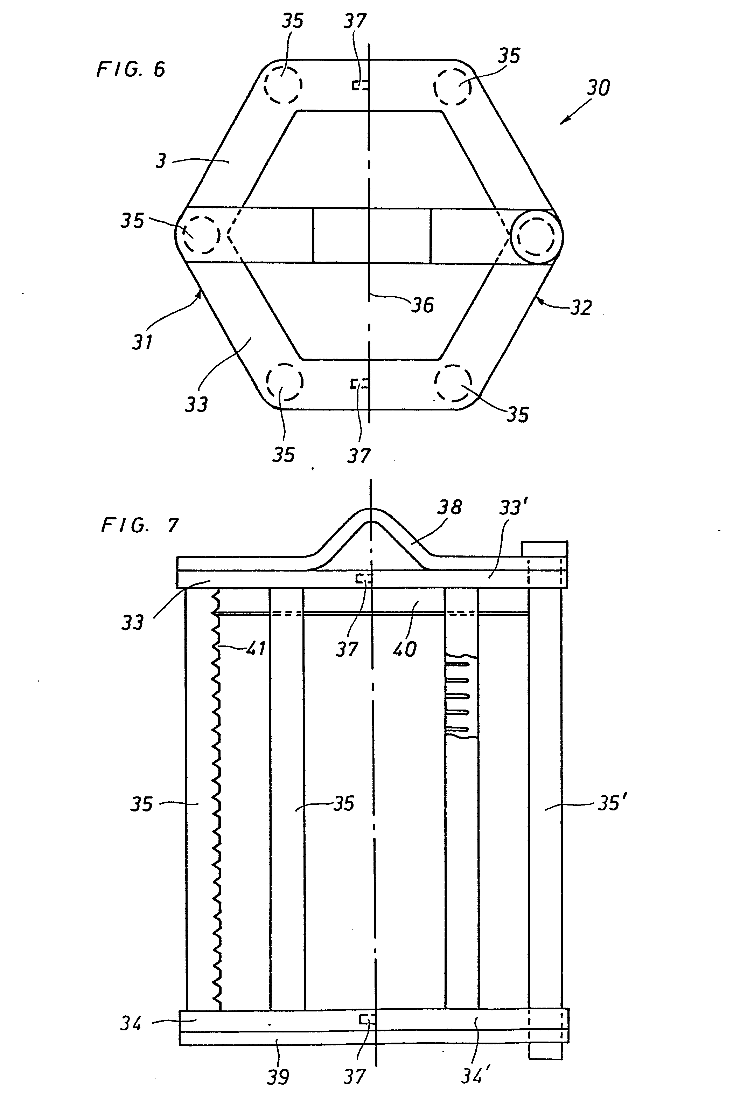

The holder shown in Fig. 6 and 7 is also designed
for use in an apparatus as shown in fig. 4 and 5.
It may be made entirely of quartz. The holder 30 is
of hexagonal shape and consists of two halves 31, 32.
Each half  is composed of upper and lower end pieces
33, 34, each forming a half of a hexagonal frame, and
three connecting rods 35. By joining the two halves
at the bisecting plane 36 a hexagonal cage may be
formed. The end faces of the end pieces of one of
the two halves may be provided with projecting centering
pins 37 which engage into respective centering recesses
of the other half. The middle connecting rod 35' of
one of the halves is not fixedly joined with the end
pieces, but losely inserted into opening of the end
pieces. It is also inserted into openings of upper and lower connecting brackets 38, 39, which are fixedly joined to the end pieces of the other half 33, 34. The upper connecting bracket 38 is provided with an upward bulge 39, into which the hook means 22 of the apparatus of fig. 4 and 5 may engage.

Upon withdrawing of the rod 35', the two halves of the hexagonal cage may be separated. The wafers 40 may then be inserted into the notches 51 of the rods 35 of one half of the cage, and the other half 32 may then be replaced, so that the wafers are held and engaged by five rods 35. By inserting the sixth rod 35', which does not have notches, the two halves are then locked together, and the whole cage or holder filled with wafers 40 may be suspended in the treatment apparatus.

Patent claims

1. A method of heat treating of semiconductor articles, such as silicon wafers, where a holder loaded with the articles is moved into and out of a heating zone defined by a substantially tubular wall and a treatment gas and/or vapour is supplied to and or exhausted from said heating zone, characterized in that said holder is moved in a substantially vertical direction without any mechanical contact with the wall of said heating zone.

2. A method as claim 1 wherein a current of treatment gas and/or vapour is created in the length direction through said heating zone  characterized in that said current is in a substantially vertical direction upward or downward.

3. A method as claimed in claim 1 or 2, characterized in that the articles are substantially disc-shaped and are arranged in said holder substantially vertically spaced from and parallel to each
other.

4.    An apparatus for carrying out the method as
claimed in one of claims 1 to 3, comprising a tube
(12), means (13) for heating at least a section of
said tube, means (14, 18, 23) for supplying to and
exhausting from said tube section a treatment gas
and/or vapour, and means (19, 20) for moving a holder (1) loaded with the articles into and out of
said tube section,   characterized in that at least
the heated tube section is arranged with its axis
substantially vertical and said means for moving
the holder comprise supporting  and lifting means
(19, 20, 21) adapted to support,  raise and lower
the holder (1) into and out of said tube section
without contact with the wall thereof.

5.    An apparatus as claimed in claim 4,   characterized in that said means comprise a suspension (21)
for said holder (1) and means (19, 20) to raise and
lower said suspension.

6.    An apparatus as claimed in claim 4,   characterized in that said means comprise a cover (15) for said tube (12), means (21) for suspending said cover, and lifting means (19, 20) for raising and lowering said cover.

7.    An apparatus as claimed in claims 4 to 6, characterized by gas and or vapour supplying and exhausting means for generating a current of treatment gas and/or vapour upward or downward through said substantially vertical tube section.

8.    An apparatus as claimed in any of claims 4 to 7,   characterized in that said holder (1) comprises an elongated, generally trough-shaped structure (2, 3, 4) open at one side for inserting the semiconductor wafers (5), locating means (6) for locating said wafers (5) in a substantially parallel, spaced relationship, releasable locking means (8) for locking the inserted wafers, and means (10, 21, 22) for suspending the holder from one end of said trough-shaped structure.

9.    An apparatus as claimed in claim 8,  characterized in that said trough-shaped structure comprises
two end pieces (2, 3) and a plurality of parallel
rods (4) connecting said end pieces, and said locking
means comprise a locking rod (8) insertable through
openings (7) in said end pieces (2, 3) in a position
parallel to said rods (4) and engaging the upper edges
(9) of the inserted wafers (5).

10.    An apparatus as claimed in claim 8, characterized in that said locating means comprise  quidistant
slots or notches (6) in said rods (4).

11.    An apparatus as claimed in any of claims 8 to
10,    characterized in that all parts of the holder
(1) and the  suspension (20, 21) are made of quartz
or similar material.

0077408

Fig. 1

Fig. 2

Fig. 3

Fig. 4

Fig.5

0077408

FIG. 6

FIG. 7

European Patent
Office

**EUROPEAN SEARCH REPORT**

EP 81 10 8421.9

## DOCUMENTS CONSIDERED TO BE RELEVANT

| Category | Citation of document with indication, where appropriate, of relevant passages | Relevant to claim |
|---|---|---|
| A | US - A - 4 082 865 (RCA CORP.) <br> * column 3, line 27 to column 4, line 2 * | 1,3,4 |
| A | GB - A - 1 302 993 (SIEMENS AG) <br> * page 1, line 88 to page 2, line 66 * | 1,4 |
| A | DE - U1 - 7 416 254 (SEMIKRON) <br> * page 2, last paragraph to page 3, last paragraph * | 1,3,4,5, <br> 8-10 |
| A | GB - A - 1 436 503 (HERAEUS QUARZSCHMELZE GMBH) <br> * page 1, line 85 to page 2, line 74 * | 8,10,11 |

### CLASSIFICATION OF THE APPLICATION (Int. Cl. 3)

H 01 L 21/68

C 30 B 35/00

### TECHNICAL FIELDS SEARCHED (Int.Cl. 3)

C 23 C 11/00

C 30 B 25/12

C 30 B 31/14

C 30 B 35/00

H 01 L 21/18

H 01 L 21/68

### CATEGORY OF CITED DOCUMENTS

X: particularly relevant if taken alone
Y: particularly relevant if combined with another document of the same category
A: technological background
O: non-written disclosure
P: intermediate document
T: theory or principle underlying the invention
E: earlier patent document, but published on, or after the filing date
D: document cited in the application
L: document cited for other reasons

&: member of the same patent family, corresponding document

The present search report has been drawn up for all claims

| Place of search | Date of completion of the search | Examiner |
|---|---|---|
| Berlin | 02-06-1982 | GIBBS |

EPO Form 1503.1   06.78